# EUROPÄISCHE PATENTSCHRIFT

(11) **EP 1 419 539 B1**
(45) Veröffentlichungstag und Bekanntmachung des Hinweises auf die Patenterteilung: **21.06.2006**
(21) Anmeldenummer: 02751087.4
(22) Anmeldetag: 28.06.2002
(51) Int. Cl.: H01L 41/053, H01L 41/083

(54) **MONOLITHISCHER VIELSCHICHTAKTOR IN EINEM GEHÄUSE**
MONOLITHIC MULTILAYER ACTUATOR IN A HOUSING
ACTIONNEUR MULTICOUCHE MONOLITHIQUE DANS UN BOITIER

(30) Priorität: 12.07.2001 DE 10134035; 14.03.2002 DE 10211107
(43) Veröffentlichungstag der Anmeldung: 19.05.2004
(73) Patentinhaber: CeramTec AG Innovative Ceramic Engineering, 73207 Plochingen (DE)
(72) Erfinder: BINDIG, Reiner, 95463 Bindlach (DE); SCHREINER, Hans-Jürgen, 91233 Neunkirchen am Sand-Rollhofen (DE); SIMMERL, Matthias, 91239 Henfenfeld (DE); SCHMIEDER, Jürgen, 91207 Lauf (DE); STEICHELE, Thilo, 90482 Nürnberg (DE)
(74) Vertreter: Scherzberg, Andreas Hans
(86) Internationale Anmeldenummer: PCT/EP2002/007171
(87) Internationale Veröffentlichungsnummer: WO 2003/009400

(56) Entgegenhaltungen:
- EP-A- 0 319 038
- WO-A-99/30374
- DE-A- 3 833 109
- PATENT ABSTRACTS OF JAPAN vol. 017, no. 213 (E-1356), 26. April 1993 (1993-04-26) & JP 04 349675 A (HITACHI METALS LTD), 4. Dezember 1992 (1992-12-04) -& JP 04 349675 A (HITACHI METALS LTD) 4. Dezember 1992 (1992-12-04)
- PATENT ABSTRACTS OF JAPAN vol. 1995, no. 07, 31. August 1995 (1995-08-31) & JP 07 094799 A (NIKON CORP), 7. April 1995 (1995-04-07) -& JP 07 094799 A (NIKON CORP) 7. April 1995 (1995-04-07)

## Beschreibung

Die Erfindung betrifft einen monolithischen Vielschichtaktor nach dem Oberbegriff des Anspruchs 1.

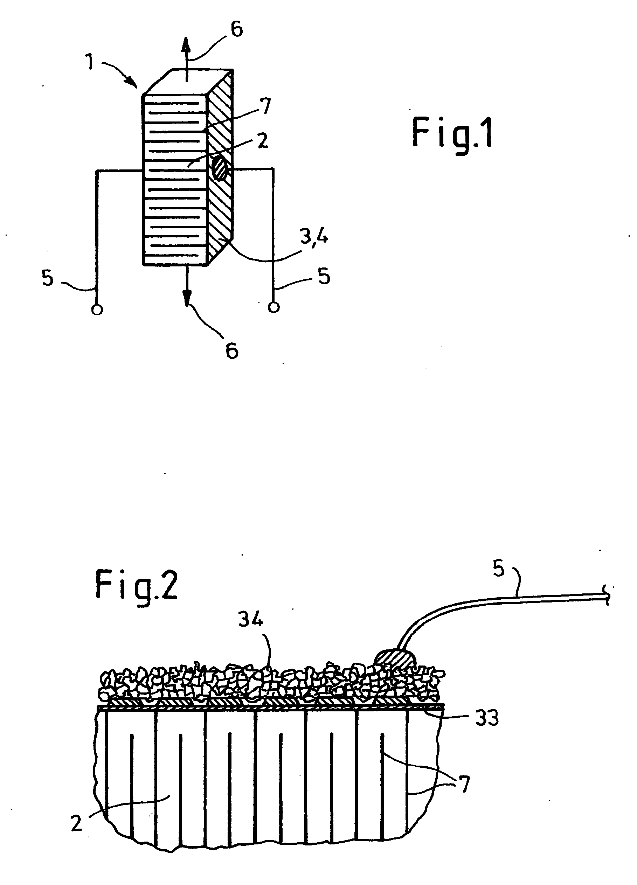

Piezokeramische Vielschichtaktoren (PMA, siehe Figur 1) bestehen aus gestapelten dünnen Schichten piezoelektrisch aktiven Materials 2, z. B. Blei-Zirkonat-Titanat (PZT), mit dazwischen angeordneten leitfähigen Innenelektroden 7, die alternierend an die. Aktoroberfläche geführt werden. Außenelektroden. 3, 4 :verbinden diese Innenelektroden. Dadurch werden die Innenelektroden elektrisch parallel geschaltet und zu zwei Gruppen zusammengefasst, die die beiden Anschlusspole des Aktors darstellen. Legt man eine elektrische Spannung an die Anschlusspole, so wird diese auf alle Innen elektroden parallel übertragen und verursacht ein elektrisches Feld in allen Schichten aktiven Materials, das sich dadurch mechanisch verformt. Die Summe aller dieser mechanischen Verformungen steht an den Endflächen des Aktors als nutzbare Dehnung 6 und/oder Kraft zur Verfügung. Über elektrische Anschlussdrähte 5 werden die Anschlusspole angesteuert.

Piezokeramische Vielschichtaktoren werden nach dem Stand der Technik als Monolithen ausgeführt, d. h. das aktive Material wird vor dem Sintern als sogenannte Grün-Folie durch ein Siebdruckverfahren mittels Edelmetallpaste mit Innenelektroden versehen, zu Aktorstapeln verpresst, pyrolysiert und dann gesintert, wodurch der monolithische Aktor entsteht.

Die Oberflächen des Aktorkörpers werden nun durch ein formgebendes Verfahren, im allgemeinen durch Schleifen bearbeitet. Auf den Aktor 1 wird im Bereich der herausgeführten Innenelektroden 7, z. B. durch galvanische Verfahren oder Siebdruck von Metallpaste eine Grundmetallisierung 33 aufgebracht. Diese Grundmetallisierung wird verstärkt durch Aufbringen eines metallischen Werkstoffes 34, z. B. durch Anlöten eines strukturierten Bleches oder eines Drahtnetzes. An diese verstärkte Schicht wird der elektrische Anschlussdraht 5 gelötet. Vor oder nach dem Anlöten der Anschlussdrähte wird der Aktor mit einer elektrisch isolierenden Beschichtung überzogen, die zudem vor mechanischer Verletzung der Aktoroberflächen schützt.
Figur 1 zeigt einen PMA allgemein, Figur 2 zeigt weitere Details.

Der Aufbau und die Herstellung derartiger Aktoren und Außenelektroden wird ausführlich beschrieben z. B. in DE 33 30 538 A1, DE 40 36 287 C2, US 5 281 885, US 4 845 399, US 5 406 164 und JP 07-226541 A.

Viele Anwendungen für Aktoren stellen die Forderung, dass das Bauteil über lange Zeiträume mit der Nennspannung beaufschlagt werden kann, ohne dass es seine Eigenschaften ändert. Typisch Anwendungen sind Stell- und Positionierantriebe, die eine bestimmte Position anfahren, und unter Umständen über Monate und Jahre halten müssen. Diese Anforderung kann mit Aktoren nach dem oben beschriebenen Stand der Technik nicht erfüllt werden.

Ursache hierfür ist, dass durch die hohe elektrische Feldstärke an der Aktoroberfläche polare Moleküle, gewöhnlich Wasserdampf, aus der Umgebung angezogen werden. Dieser Wasserdampf durchdringt alle bekannten polymeren Umhüllungen mehr oder weniger schnell und führt schließlich an der Aktoroberfläche zu erhöhter Leitfähigkeit und zu ansteigendem Leckstrom. Der Leckstrom steigt solange an bis sich durch die ebenfalls ansteigende Aktortemperatur ein Gleichgewicht für Wasserdampfadsorption durch das elektrische Feld und Desorption durch die Aktortemperatur einstellt. Den typischen Leckstromverlauf über der Zeit für einen Aktor mit den Abmessungen 7 x 7 x 30 mm³ bei einer inneren Feldstärke von 2000 V/mm unter normalen Laborumgebungsbedingungen zeigt das Diagramm 1 bei 200 V, 25° C, 40 % rF.

Verwendet man als Überzug keramische Beschichtungen oder Gläser, so dringt der Wasserdampf durch Mikrorisse der Beschichtung, die sich zwangsläufig durch den Betrieb des Aktors bilden.

Auch das Umgießen mit einer geeigneten Vergussmasse in einem Metallgehäuse führt nicht zum Erfolg, da bereits die äußerst geringen Wassermengen, die in der Vergussmasse enthalten sind oder die während des Verkapselungsschrittes eindringen, genügen, den Effekt auszulösen.

Einen weiteren Schwachpunkt bilden die Anschlussdrähte, die durch die Beschichtung, beziehungsweise das Gehäuse, nach außen geführt werden müssen. Durch Polymere geführte isolierte Drähte führen aus oben genannten Gründen nicht zum Ziel. Metall/Glas Durchführungen führen zu Problemen, weil sie durch die Bewegung des Aktors zerstört werden.

Die gattungsbildende JP 04-349675 A mit zugehörigem Abstract zeigt einen monolithischen Vielschichtaktor aus einem gesinterten Stapel dünner Folien aus Piezokeramik mit eingelagerten metallischen Innenelektroden, die wechselseitig aus dem Stapel herausführen und über Außenelektroden elektrisch parallel geschaltet sind und mit Anschlussdrähten versehen sind, wobei der Vielschichtaktor von einem Gehäuse mit einem Gehäusemantel, einem Gehäusedeckel und einem Gehäuseboden dichtend umschlossen ist und das Gehäuse mit einem wasserabsorbierenden Medium gefüllt ist.

EP 0 319 038 A2 und WO 99/303 74 A1 zeigen ebenfalls einen monolitischen Vielschichtaktor, jedoch wird auf die Problematik, dass auch kleinste Undichtigkeiten durch eindringende Feuchtigkeit zu einer Änderung der Eigenschaften des Aktors führen, nicht eingegangen.

Der Erfindung liegt die Aufgabe zugrunde, einen Vielschichtaktor nach dem Oberbegriff des Anspruchs 1 so zu verbessern, dass die Aktoren über lange Zeiträume mit der Nennspannung beaufschlagt werden können, ohne dass dieser seine Eigenschaften ändert.

Erfindungsgemäß wird diese Aufgabe durch die Merkmale des Anspruchs 1 gelöst. Erfindungsgemäß ist der Vielschichtaktor von einem metallischen oder keramischen Gehäuse dichtend umschlossen, wobei die Anschlussdrähte integrale Bestandteile des Gehäusebodens sind und das Gehäuse mit einem wasserabsorbierenden Medium und einem wassertransportierenden, elektrisch isolierenden Medium gefüllt ist.

Derartig gekapselte Aktoren zeigen konstant niedrige Leckströme, auch wenn sie permanent mit der Nennfeldstärke betrieben werden. Diagramm 2 zeigt den Leckstromverlauf an einem derart gekapselten Aktor. Aktorabmessungen und sonstige Parameter entsprechen der Messung aus Diagramm 1. Der Leckstrom des gekapselten Bauteils ist etwa 1000 mal kleiner als der des ungekapselten Aktors. Verwendet wurde ein Keramikgehäuse, Silikat-Trockenmittel und eine Perfluorpolyäther-Füllung.

Durch die eventuell vorhandene elastische Deckelfuge eindiffundierendes, oder bereits im Gehäuse vorhandenes Wasser, wird dadurch abgefangen und unschädlich gemacht.

Erfindungsgemäß besteht das Gehäuse aus einem Gehäusemantel, insbesondere rohrförmigen Gehäusemantel, mit einem Gehäusedeckel und einem Gehäuseboden, wobei der Gehäusedeckel mit einem dauerelastischen Dichtmedium auf den Gehäusemantel aufgesetzt ist.

Der Gehäuseboden besteht aus Keramik.

Die Anschlussdrähte sind in Form von Leiterbahnen auf den Gehäuseboden aufgebracht.

Bevorzugt werden die Leiterbahnen mit dem Dickschichtverfahren (Aufdrucken von Metallpaste und Einbrennen dieser in den Gehäuseboden) hergestellt.

An die Anschlussdrähte bzw. die Leiterbahnen ist vorteilhafter Weise außerhalb des Gehäusemantels ein Steckverbinder angelötet.

Erfindungsgemäß ist das wassertranspvrtierende, elektrisch isolierende Medium eine Flüssigkeit und stammt insbesondere aus den Klassen der Silikonöle oder der perfluorierten Kohlenstoffverbindungen. Bevorzugt ist das wassertransportierende, elektrisch isolierende Medium perfluorierter Polyäther.

Das wasserabsorbierende Medium ist eine Silikatverbindung, wasserfreies Calciumoxid oder eine hygroskopische Substanz, wie Calciumchlorid oder Lithiumchlorid und besteht insbesondere aus Trockengel oder einem Molekularsieb.

Nachfolgend wird die Herstellung des erfindungsgemäßen Vielschichtaktors im einzelnen beschrieben.

Eine niedrig sinternde Piezokeramik, z. B. SKN53 nach DE 198 40 488 A1 wird mit einem organischen Bindersystem als 125 µm dicke Folie präpariert. Auf diese Folie wird eine handelsübliche Innenelektrodenpaste mittels Siebdruck aufgebracht. Eine Vielzahl derartiger Folien wird gestapelt und zu einem Laminat verpresst, wobei an Ober- und/oder Unterseite des Laminates einige Folien ohne Innenelektroden bleiben, um einen inaktiven Bereich zu erzeugen, an dem der Aktor später elektrisch kontaktiert werden kann. Das Laminat wird zu einzelnen, stabförmigen Aktoren zertrennt, diese werden bei 900°C - 1100 °C, vorzugsweise bei 1000 °C gesintert. Nach dem Schleifen der Aktoroberflächen wird die Grundmetallisierung 33 aus Silber mittels eines Siebdruck/Einbrennprozesses auf die Kontaktseiten aufgebracht. Die Außenelektroden aus Metalldraht-Netz werden darauf aufgelötet. Zum Schutz vor mechanischer Beschädigung und zur elektrischen Isolation bei den folgenden Messvorgängen werden die Aktoren nun mit einem handelsüblichen Silikonlack isoliert. Silikon hat von allen bekannten Lacktypen die höchste Durchlässigkeit für Wasserdampf. Die Aktoren können nun polarisiert und elektrisch gemessen werden.

Ein Aktorgehäuse wird hergestellt, indem ein Metallrohr oder Keramikrohr als Gehäusemantel 8 abgelängt wird, so dass es etwa 0,5 mm kürzer ist als der Aktor 1. Der Innendurchmesser des Rohrstückes ist derart, dass der Aktor 1 die Rohrwandung nicht berührt, wenn er in das Rohr eingefügt wird. Wird ein Metallrohr verwendet, so muss es zwei Aussparungen 10 an den Stellen erhalten, an denen die Leiterbahnen 13 des Bodenteils 11 unter dem Rohr 8 durchführen.

Ein Bodenteil 11 für das Gehäuse wird hergestellt, indem auf ein planparalleles, aber sonst beliebig geformtes Keramikplättchen mit einer Dickschichtpaste mittels Siebdruck und Einbrennen zwei Leiterbahnen 13 z. B. aus einer Silber-Pälladium Legierung aufgedruckt und eingebrannt werden, die den Kontakt zum Aktor 1 herstellen und die unter dem Keramik- oder Metallrohr 8 herausragen.

Der Aktor 1 wird nun z.B. mit einem Epoxy-Kleber derart auf das Bodenteil geklebt, dass er von den beiden Leiterbahnen 13 kontaktiert werden kann. Der Kontakt wird mittels Löten, Schweißen oder Kleben mit leitfähigem Kleber hergestellt. L-förmige Kontaktstreifen aus Metall erleichtern diesen Vorgang.

Das Aktorgehäuse bzw. der Gehäusemantel 8 wird über den Aktor 1 gesteckt, und mit dem Bodenteil 11 z. B. mit einem Epoxy-Kleber verklebt. Der Aktor 1 steht nun ca. 0,5 mm über das Gehäuse über. Er darf bei diesem Vorgang das Gehäuse nicht berühren.

Der Zwischenraum zwischen Aktor und Aktorgehäuse wird nun mit wasserabsorbierendem, pulverförmigem Medium 14 gefüllt, z.B. zerstoßenem Trockengel. Um das Pulver rieselfähig zu machen wird es auf eine bestimmte Korngröße z. B. 0,1 mm gesiebt. Das Trockenpulver wird vor dem Einfüllen bei erhöhter Temperatur entwässert. Dieses Vorgehen richtet sich aber nach der Art des verwendeten Trockenmittels. Es sind prinzipiell alle wasseranziehenden Substanzen wie z. B. Calciumoxid, Calciumchlorid, Lithiumchlorid und ähnliche verwendbar. Letztere bilden allerdings, wenn sie zuviel Wasser aufgenommen haben, eine flüssige Phase, die an der Oberfläche des Aktors zu Überschlägen führen kann. Trockenmittel auf silikatischer Basis, wie z. B. Silikagel und perowskitische Molekularsiebe, binden das Wasser im Kristallgefüge. Wenn das Trockenmittel erschöpft ist steigt der Leckstrom langsam an. Es kommt nicht zum Ausfall des Bauteils.

Das Pulverbett wird nun mit flüssigem, aber wasserleitenden Isoliermedium 15 getränkt. Dieses Isoliermedium muss vor dem Einfüllen z.B. durch Erhitzen wasserfrei gemacht werden. Es eignen sich hier vor allem Silikonöle und perfluorierte Kohlenstoffverbindungen. Silikonvergussmassen und Mineralöle sind in ihrer Wirkungsweise (Wassertransport) langsamer, eignen sich aber bei sorgfältigem, wasserfreien Arbeiten prinzipiell genauso.

Der Gehäusedeckel, der aus einem planparallelen Keramikplättchen besteht, wird z.B. mit einem Epoxy-Kleber auf den Aktor geklebt.

Die verbleibende Fuge 17 zwischen Gehäusedeckel 16 und Aktorgehäuse 8 wird mit einem dauerelastischen Dichtmedium z. B. Silikondichtmasse gefüllt.

Die oben beschriebene Vorgehensweise bei der Herstellung monolithischer Vielschichtaktoren ist, wie in der Einführung beschrieben, in der Patentliteratur und sonstigen Veröffentlichungen ausführlich diskutiert. Das erfindungsgemäße Vorgehen bei der Kapselung der Aktoren muss nicht dem beschriebenen Arbeitsablauf entsprechen. Es sind für den erfahrenen Fachmann auch ähnliche Vorgehensweisen ableitbar, die zum gleichen Ergebnis führen.

### Ausführungsbeispiel 1:

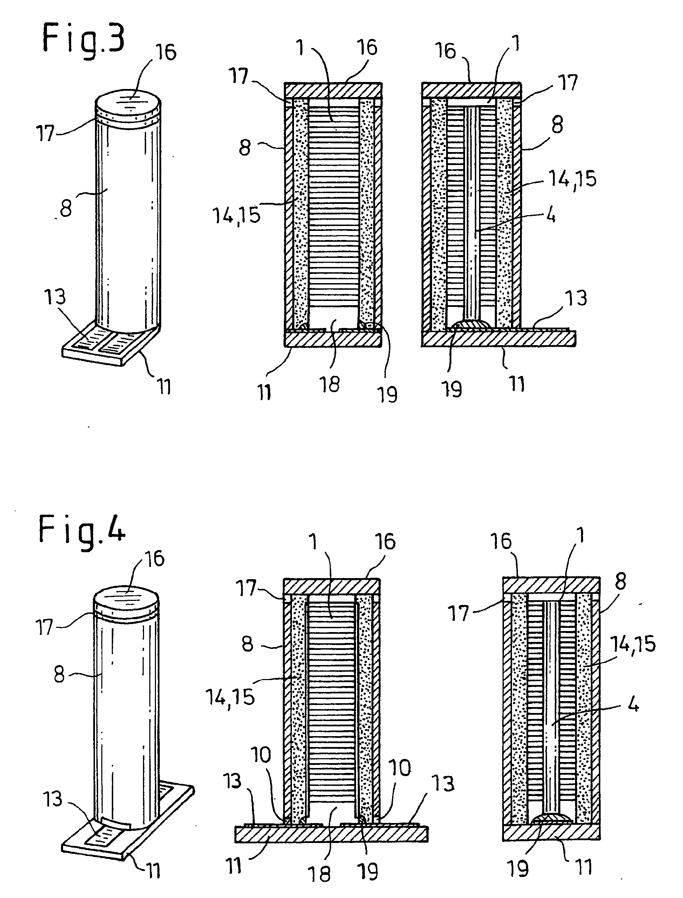

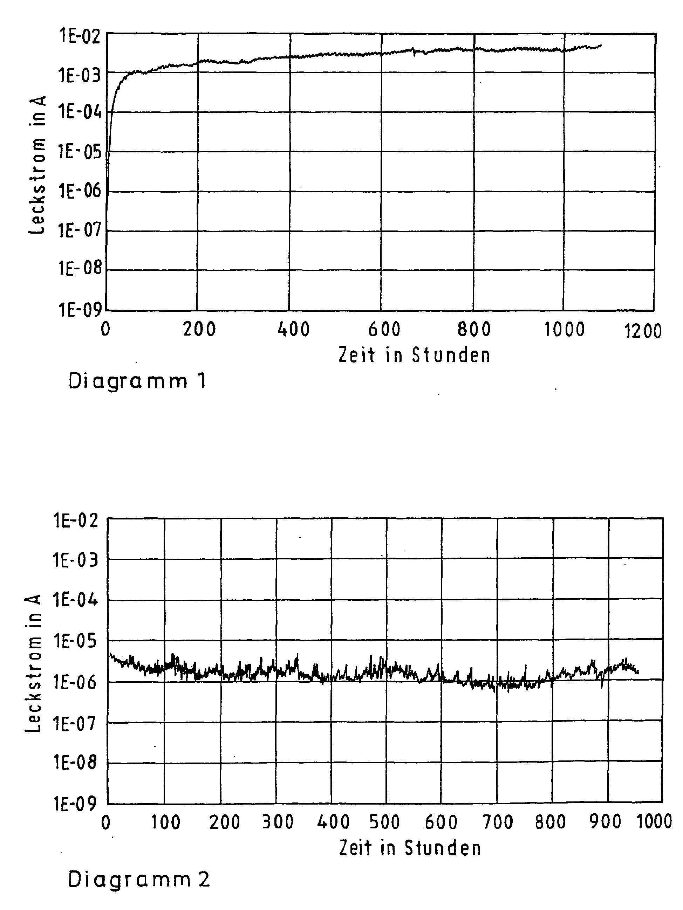

Dieses Ausführungsbeispiel ist in der Fig. 3 dargestellt.

Eine 125 µm dicke Grünfolie aus SKN53 wird hergestellt, indem man das auf eine mittlere Korngröße von ca. 1 µm gemahlene Keramikpulver mit Lösungsmitteln, organischen Bindern, Plastifizierern und Dispergierhilfen zu einem Gießschlicker aufbereitet, aus diesem mittels des Doctor-blade-Verfahrens eine Endlosfolie gießt und diese trocknet.

Eine Innenmetallisierungspaste, die als Metallpulver Silber/Palladium im Mischungsverhältnis 70/30 enthält, wird in Form des gewünschten Innenelektrodendesigns mittels Siebdruck auf die Grünfolie aufgedruckt, wobei die Dicke der Druckschicht nach der Trocknung 8 µm beträgt.

360 bedruckte Folien und 60 unbedruckte Folien werden aufeinandergelegt und bei erhöhter Temperatur zu einem Block verpresst. Der Block wird mittels eines Schneidwerkzeuges aus Hartmetall zu einzelnen, stabförmigen Aktoren zertrennt.

Die Aktoren werden bei 400 °C pyrolysiert und anschließend bei 1000 °C 10 h lang gesintert. Die Dicke der Innenelektroden beträgt danach ca. 3 µm. Nach dem Sintern betragen die Außenabmessungen der Aktoren 7,1 x 7,1 x 30,5 mm³.

Die Aktoren werden nun allseitig mit Diamantschleifscheiben auf Maß geschliffen. Nach diesem Vorgang betragen die Außenabmessungen 7 x 7 x 30 mm³.

Außenelektroden aus Silber/Palladium 80/20 werden mittels Siebdruck auf die Kontaktflächen aufgebracht und bei 800°C eingebrannt.

Ein netzartiges Drahtgeflecht (EP 0 844 678 A1) wird zur Verstärkung aufgelötet.

Die Aktoren werden nun durch einen handelsüblichen Silikon-Überzugslack geschützt.

Anschließend findet die Polarisation statt, indem bei einer Temperatur von ca. 120 °C eine Spannung von 200 V an die Bauteile gelegt wird.

Ein Rohr aus Aluminiumoxid-Keramik 8 mit einem Innendurchmesser von 10 mm, einem Außendurchmesser von 12 mm und einer Länge von 29,5 mm wird hergestellt.

Ein Aluminiumoxid-Keramik-Plättchen 11 (Gehäuseboden) mit den Abmessungen Dicke 1 mm, Länge 15 mm, Breite 12 mm wird hergestellt. Die Dicke ist planparallel geschliffen. Auf das Plättchen werden längs nebeneinander zwei Leiterbahnen 13 aus Silber/Palladium 80/20 mittels Siebdruck aufgebracht und bei 800 °C eingebrannt. Die Leiterbahnen 13 sind 14 mm lang, 5 mm breit und weisen einen Abstand von 1 mm auf.

Ein Aluminiumoxid-Keramik-Plättchen 16 (Gehäusedeckel) mit den Abmessungen Durchmesser 12 mm, Dicke 1 mm wird hergestellt. Die Dicke ist planparallel geschliffen.

Trockenpulver 14 wird hergestellt, indem Trockenmittel (Blaugel) mit einer Plattenschlägermühle gebrochen wird, und auf eine Korngröße von 50 µm bis 100 µm gesiebt wird. Das Pulver wird in einem Trockenschrank bei 120 °C ca. 10 Stunden lang wasserfrei getrocknet.

Silikonöl als Isoliermedium 15 wird bei 120° C ca. 10 Stunden lang wasserfrei getrocknet.

Ein Aktor 1 wird mit dem inaktiven Fuß 18 mittels Epoxid - Klebstoff so auf ein Bodenteil geklebt, dass unter Berücksichtigung des gesamten Gehäusedurchmessers das Bodenteil einseitig übersteht.

Die Außenelektroden 4 werden unter Benutzung von Kupferfolienstreifen mit den Leiterbahnen 13 verlötet.

Das Keramikrohr 8 wird über den Aktor geführt und mittels Epoxid - Klebstoff mit dem Bodenteil 11 verklebt. Das Bodenteil steht einseitig über.

Das Teilgehäuse mit Aktor wird nun bei 120 °C 10 h ausgeheizt. Der Zwischenraum zwischen Aktor und Gehäusewand wird mit Trockenpulver 14 gefüllt. Das Trockenpulver wird mit Silikonöl 15 getränkt. Das Deckelteil 16 wird mittels Epoxid - Klebstoff mittig auf den Aktor aufgeklebt. Bei diesen Schritten soll die Temperatur des Gehäuses nie unter 100 °C fallen.

Nach dem Abkühlen wird die verbleibende Fuge 17 zwischen Gehäusedeckel und Gehäuse mit Silikondichtmasse gefüllt.

An die überstehenden Leiterbahnen 13 des Bodenteils wird ein Steckverbinder (Leiterplattenverbinder) gelötet.

Derart gekapselte Aktoren weisen bei Ansteuerung mit einer Gleichspannung von 200 V folgende Eigenschaft auf:

Nach Abklingen des Ladestroms fließen etwa 1 bis 2 µA Leckstrom. Dieser Leckstrom ist auch nach 3000 h unverändert.

### Ausführungsbeispiel 2:

Das Ausführungsbeispiel ist in der Fig. 4 dargestellt.

Piezoelektrische monolithische Vielschichtaktoren werden wie in Ausfdhrungsbeispiel 1 hergestellt.

Ein Rohr aus Aluminium 8 mit einem Innendurchmesser von 10 mm, einem Außendurchmesser von 10,5 mm und einer Länge von 29,5 mm wird hergestellt. Das Rohr erhält zwei Aussparungen 10 mit den Abmessungen 0,5 mm hoch und 5 mm breit.

Ein Aluminiumoxid-Keramik-Plättchen 11 (Gehäuseboden) mit den Abmessungen Dicke 1 mm, Länge 16,5 mm, Breite 10,5 mm wird hergestellt. Die Dicke ist planparallel geschliffen. Auf das Plättchen werden längs hintereinander zwei Leiterbahnen 13 aus Silber/Palladium 80/20 mittels Siebdruck aufgebracht und bei 800 °C eingebrannt. Die Leiterbahnen sind 7,5 mm lang, 4 mm breit und weisen einen Abstand von 1 mm auf.

Ein Aluminiumoxid-Keramik-Plättchen 16 (Gehäusedeckel) mit den Abmessungen Durchmesser 12 mm, Dicke 1 mm wird hergestellt. Die Dicke ist planparallel geschliffen.

Als Trockenpulver 14 wird gemahlenes wasserfreies Calciumoxid verwendet.

Als Isoliermedium 15 wird perfluorierter Polyäther verwendet, dessen Kettenlänge so eingestellt ist, dass sich eine Siedetemperatur von 240 °C ergibt. Das Medium wird mehrere Minuten auf Siedetemperatur erhitzt, um es wasserfrei zu erhalten.

Ein Aktor wird mit dem inaktiven Fuß 18 mittels Epoxid - Klebstoff mittig auf ein Bodenteil geklebt, so dass die Außenelektroden 4 mit den Leiterbahnen des Bodenteils verbunden werden können.

Die Außenelektroden 4 werden unter Benutzung von Kupferfolienstreifen mit den Leiterbahnen 13 verlötet.

Das Aluminiumrohr 8 wird über den Aktor 1 geführt, so dass die Aussparungen über den Leiterbahnen 13 liegen und mittels Epoxid - Klebstoff mit dem Bodenteil 11 verklebt. Das Bodenteil steht beidseitig über. Die Aussparungen 10 füllen sich mit dem Klebstoff und sind damit verschlossen.

Das Teilgehäuse mit Aktor wird nun bei 120 °C 10 h ausgeheizt. Der Zwischenraum zwischen Aktor und Gehäusewand wird mit dem Trockenpulver 14 gefüllt. Das Trockenpulver 14 wird mit dem Isoliermedium 15 getränkt. Das Deckelteil 16 wird mittels Epoxid - Klebstoff mittig auf den Aktor aufgeklebt. Bei diesen Schritten soll die Temperatur des Gehäuses nie unter 100 °C fallen.

Nach dem Abkühlen wird die verbleibende Fuge 17 wischen Gehäusedeckel und Gehäuse mit Silikondichtmasse gefüllt.

An die überstehenden Leiterbahnen 13 des Bodenteils werden zwei Steckverbinder (Leiterplattenverbinder) gelötet.

Derart gekapselte Aktoren weisen danach bei Ansteuerung mit einer Gleichspannung von 200 V folgende Egenschaft auf:

Nach Abklingen des Ladestroms fließen etwa 2 bis 3 µA Leckstrom. Dieser Leckstrom ist auch nach 3000 h unverändert. Kapselungen dieser Art sind in der Tendenz etwas ungünstiger, da durch die kurze Isolierstrecke Leiterbahn-Gehäuse-Leiterbahn ein erheblicher Leckstrom fließt der den insgesamt zu messenden Leckstrom erhöht.

### Zeichnungen:

Fig. 1: Aufbau eines monolithischen Vielschichtaktors
Fig. 2: Detailansicht von Fig.1
Fig. 3: Erfindungsgemäß gekapselter Aktor im Keramikgehäuse, Außenansicht, zwei Schnitte
Fig. 4: Erfindungsgemäß gekapselter Aktor im Keramikgehäuse, Außenansicht, zwei Schnitte
Diagramm 1: Leckstromverhalten eines Standardaktors ohne Kapselung
Diagramm 2: Leckstromverhalten eines erfindungsgemäß gekapselten Aktors

## Patentansprüche

1. Monolithischer Vielschichtaktor (1) aus einem gesinterten Stapel dünner Folien aus Piezokeramik mit eingelagerten metallischen Innenelektroden, die wechselseitig aus dem Stapel herausführen und über Außenelektroden (3, 4) elektrisch parallel geschaltet sind und mit Anschlussdrähten (5) versehen sind,
wobei der Vielschichtaktor (1) von einem Gehäuse mit einem Gehäusemantel (8), einem Gehäusedeckel (16) und einem Gehäuseboden (11) dichtend umschlossen ist
und das Gehäuse (8, 11, 16) mit einem wasserabsorbierenden Medium (14) gefüllt ist,
**dadurch gekennzeichnet,**
**dass** der Vielschichtaktor (1) von einem metallischen oder keramischen Gehäuse (8, 11, 16) dichtend umschlossen ist,
wobei der Gehäuseboden (11) aus Keramik besteht und
der Gehäusedeckel (16) mit einem dauerelastischen Dichtmedium auf den Gehäusemantel (8) aufgesetzt ist,
die Anschlussdrähte (5) integrale Bestandteile des Gehäusebodens (11) sind und in Form von Leiterbahnen (13) auf den Gehäuseboden (11) aufgebracht sind,
das wasserabsorbierende Medium (14) ein pulverförmiges Medium ist und eine Silikatverbindung, wasserfreies Calciumoxid oder eine hygroskopische Substanz, wie Calciumchlorid oder Lithiumchlorid, ist und insbesondere aus Trockengel oder einem Molekularsieb besteht und
das Gehäuse mit einem wassertransportierenden, elektrisch isolierenden Medium (15) gefüllt ist und das wassertransportierende, elektrisch isolierende Medium (15) eine Flüssigkeit ist und aus den Klassen der Silikonöle oder der perfluorierten Kohlenstoffverbindungen stammt und bevorzugt ein perfluorierter Polyäther ist,
wobei das wasserabsorbierende Medium (14) mit dem wassertransportierenden, elektrisch isolierenden Medium (15) getränkt ist.

2. Vielschichtaktor nach Anspruch 1, **dadurch gekennzeichnet, dass** die Leiterbahnen (13) mit dem Dickschichtverfahren (Aufdrucken von Metallpaste und Einbrennen dieser in den Gehäuseboden (11)) hergestellt sind.

3. Vielschichtaktor nach Anspruch 1 oder 2, **dadurch gekennzeichnet, dass** an die Anschlussdrähte (5) bzw. Leiterbahnen (11) außerhalb des Gehäusemantels (8) ein Steckverbinder angelötet ist.

## Claims

1. Monolithic multilayer actuator (1) of a sintered stack of thin films of a piezoceramic material with inlaid metallic internal electrodes that project in an alternating manner from the stack and are electrically connected in parallel by external electrodes (3, 4) and are provided with connecting wires (5),
wherein the multilayer actuator (1) is hermetically enclosed by a housing jacket (8), a housing cover (16) and a housing floor (11),
and the housing (8, 11, 16) is filled with a water-absorbing medium (14),
**characterised in that**
the multilayer actuator (1) is hermetically enclosed by a metallic or ceramic housing (8, 11, 16),
wherein the housing floor (11) consists of ceramic material
and the housing cover (16) together with a permanently elastic sealing medium is mounted on the housing jacket (8),
the connecting wires (5) are integral constituents of the housing floor (11) and are applied in the form of conducting tracks (13) to the housing floor (11),
the water-absorbing medium (14) is a pulverulent medium and is a silicate compound, anhydrous calcium oxide or a hygroscopic substance such as calcium chloride or lithium chloride, and consists in particular of dry gel or a molecular sieve,
and the housing is filled with a water-transporting, electrically-insulating medium (15) and the water-transporting, electrically-insulating medium (15) is a liquid and is derived from the classes of silicone oils or perfluorinated carbon compounds and is preferably a perfluorinated polyether,
wherein the water-absorbing medium (14) is impregnated with the water-transporting, electrically insulating medium (15).

2. Multilayer actuator according to claim 1, **characterised in that** the conducting tracks (13) are produced by the thick-film method (pressing metal paste into the housing floor (11) followed by stoving).

3. Multilayer actuator according claim 1 or 2, **characterised in that** a connector is soldered onto the connecting wires (5) or conducting tracks (11) outside the housing jacket (8).

## Revendications

1. Actionneur multicouche monolithique composé d'une pile frittée de minces feuilles en piézocéramique, avec des électrodes internes métalliques intercalées, qui dépassent alternativement d'un côté et de l'autre de la pile et qui sont connectées électriquement en parallèle par des électrodes externes (3, 4) et comportent des fils de raccordement (5), cet actionneur (1) étant entouré avec étanchéité par un boîtier constitué d'une enveloppe de boîtier (8), d'un couvercle de boîtier (16) et d'un fond de boîtier (11), ce boîtier (8, 11, 16) étant rempli d'un agent (14) absorbant l'eau,
**caractérisé en ce que**
- l'actionneur multicouche (1) est enveloppé de manière étanche par un boîtier (8, 11, 16) métallique ou céramique,
- le fond de boîtier (11) est en céramique,
- le couvercle de boîtier (16) est appliqué sur l'enveloppe de boîtier (8) avec un agent d'étanchéité à élasticité durable,
- les fils de raccordement (5) sont des composants intégraux du fond de boîtier (11) et sont déposés sous forme de pistes conductrices (13) sur le fond de boîtier (11),
- l'agent (14) absorbant l'eau est un agent en forme de poudre, fait d'un composé de silicate, d'un oxyde de calcium déshydraté ou d'une substance hygroscopique telle que du chlorure de calcium ou du chlorure de lithium, et il est composé en particulier d'un gel sec ou d'un tamis moléculaire,
- le boîtier est rempli d'un agent (16) isolant électrique et transportant de l'eau, cet agent étant un liquide appartenant aux classes des huiles de silicone ou des composés de carbone perfluorés et il est de préférence un polyéthylène perfluoré,
- l'agent (14) absorbant l'eau est humecté avec l'agent (15) isolant électrique transportant de l'eau.

2. Actionneur multicouche selon la revendication 1, **caractérisé en ce que** les pistes conductrices (13) sont fabriquées selon le procédé à couche épaisse (application d'une pâte métallique sur le fond de boîtier (11) et brûlage de celle-ci.

3. Actionneur multicouche selon la revendication 1 ou 2, **caractérisé en ce qu'**un connecteur enfichable est brasé sur les fils de raccordement (5) ou les pistes conductrices (1) à l'extérieur de l'enveloppe de boîtier (8).
